(19) Europäisches Patentamt
European Patent Office
Office européen des brevets

(11) EP 2 091 087 A1

(12) # EUROPEAN PATENT APPLICATION
published in accordance with Art. 153(4) EPC

(43) Date of publication:
**19.08.2009 Bulletin 2009/34**

(21) Application number: **07792994.1**

(22) Date of filing: **27.08.2007**

(51) Int Cl.:
***H01L 31/042*** *(2006.01)* ***B32B 27/00*** *(2006.01)*

(86) International application number:
**PCT/JP2007/066517**

(87) International publication number:
**WO 2008/029651 (13.03.2008 Gazette 2008/11)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **04.09.2006 JP 2006238605**

(71) Applicant: **Toray Industries, Inc.**
**Tokyo, 103-8666 (JP)**

(72) Inventors:
- **MIYAJI, Shinichiro**
**Tokyo 103-8666 (JP)**
- **NOGUCHI, Masakazu**
**Tokyo 103-8666 (JP)**
- **KAWAJI, Naoki**
**Anpachi-gun**
**Gifu 503-2395 (JP)**

(74) Representative: **Kador & Partner**
**Corneliusstrasse 15**
**80469 München (DE)**

(54) **SEAL FILM FOR SOLAR CELL MODULE AND SOLAR CELL MODULE UTILIZING THE SAME**

(57) An object of the present invention is to provide a seal film for solar cell module further excelling in long-term reliability and solar cell module using the same. The excellence in long-term reliability is achieved by using a PPS film excelling in heat resistance and hydrolysis resistance in at least a portion of the solar cell seal film to thereby not only reinforce the seal film against deterioration by external environment but also to prevent deterioration of the gas barrier property thereof due to long-term use having been a problem of the prior art so as to attain well-balanced environmental resistant properties (heat resistance, hydrolysis resistance, weather resistance, chemical resistance, and the like). Provided is a seal film for solar cell module including a resin film layer including a biaxially oriented film layer formed of a resin composition containing poly-p-phenylene sulfide as a major component; and a gas barrier layer formed of at least one selected from the group consisting of a metal, a metal oxide, an inorganic compound, and an organic compound. In the seal film for solar cell module, longitudinal and width direction heat shrink ratios at 150°C of the seal film for solar cell module both fall within a range of -2. 0% to +2.0%, and an absolute value of a difference between the longitudinal and width direction heat shrink ratios at 150°C is 2.0% or less.

Fig. 1

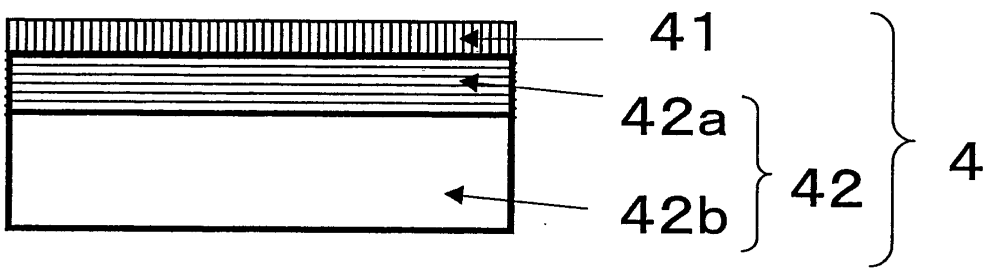


EP 2 091 087 A1

## Description

TECHNICAL FIELD

The present invention relates to a seal film for solar cell module having a gas barrier layer and, also relates to a solar cell module using the seal film.

More specifically, the present invention relates to a seal film for solar cell module excellent in long-term reliability with a significantly improved weather resistance such as hydrolysis resistance and ultra-violet resistance, resulting from a markedly improved durability of a gas barrier layer and also relates to a solar cell module using the seal film.

BACKGROUND ART

In recent years, a solar cell has attracted attention as a next generation energy source and has widely been used in residential and industrial applications.

A demand for a solar cell with a longer life of 20 to 30 years (long-term use reliability) is particularly increased with the growing popularization of the solar cell.

Requests for the long-term reliability (long-term durability) of a gas barrier layer provided to block water and oxygen, for the prevention of deterioration of the seal film by hydrolysis as well as the provision of characteristics such as ultra-violet resistance to the seal film, and the like, and further for total improvement in weather resistance with these characteristics combined together have been increased day by day.

The seal film for solar cell module also needs to be excellent in processability and to have mechanical properties (toughness and the like) for protecting internal solar cell and for withstanding long-term use.

In addition, chemical-resistance to withstand a harsh environment where various kinds of gases are generated such as those in a hot spring area, a sewage facility and the like has been demanded for the seal film. Also, the achievement of electrical insulation and reduced weight which are the basic characteristics of the seal film for solar cell module is of course desired.

Conventionally-known seal films for solar cell module generally include ones described in the following items (1) to (6) .

(1) A seal film formed of a base material of a fluorine resin sheet and/or a polyethylene terephthalate film (hereinafter sometimes abbreviated to a PET film) and a several tens μm thick aluminum foil provided on the base material film as a gas barrier layer is commercially available.

(2) A seal film formed of a weather resistant film such as a fluorine resin sheet or the like and a vapor-deposited layer made of a transparent inorganic compound is proposed to improve weather resistance (refer to for example Patent Document 1).

(3) A seal film having a laminated construction with a metal oxide-deposited layer/a white resin film layer is proposed to achieve a laminated construction in which a hydrolysis resistant PET film and a gas barrier film are stacked (refer to for example Patent Document 2).

(4) A seal film formed of a PET film and a gas barrier layer and improved in hydrolysis resistance, weather resistance and reflection efficiency is proposed (refer to for example Patent Document 3).

(5) For use in a harsh environment such as that of a volcano, a hot spring, and a water or sewer treatment facility, a solar cell module provided with a poly-p-phenylene sulfide (hereinafter sometimes abbreviated to PPS) layer as a gas resistant layer in the outermost layer of a seal film for solar cell module (refer to for example Patent Document 4) and a solar cell module provided with a PPS layer as a gas barrier layer (refer to for example Patent Document 5) are proposed.

(6) It is known that a biaxially oriented PPS film is used as an electrical insulator having heat resistance because of its excellent heat resistance and hydrolysis resistance (moisture and heat resistance) (refer to for example Patent Document 6) .

However, the conventional seal films described above in items (1) to (6) have some of the following problems and accordingly have not sufficiently widely been applied to a seal film for solar cell module.

For example, the seal film described above in item (1) using an aluminum foil as the gas barrier layer is excellent in gas barrier properties but questionable in electrical insulation and weight reduction.

In addition, the seal film described above in item (2) is excellent in weather resistance and hydrolysis resistance and has a small fluctuation in gas barrier properties because the seal film uses a fluorine-based film as the base. However, the seal film has a low effect of increasing the mechanical strength of the solar cell module, possibly resulting in a broken solar cell element because of a low mechanical strength (low stiffness) of the fluorine-based film. Also, the seal film is inferior in processability, for example, in bonding.

In the seal films described above in items (3) and (4), the deterioration of the film due to hydrolysis can be prevented because of the use of a hydrolysis resistant PET film. The films, however, have a problem that gas barrier properties deteriorate by long-term use, thereby resulting in a tendency for the reduction in the output of the solar cell module to occur. In addition, the films have another problem that the deterioration of the seal film proceeds in a short time due to the deteriorations by heat resistance, hydrolysis and generated toxic gas in an atmosphere including a high temperature, a high humidity, a specific toxic gas and the like in a hot spring area, a sewer treatment facility and the like, resulting in rapid reduction in the life of the solar cell module.

The seal film described above in item (5) has an effect of preventing the deterioration of the seal film in an external environment in an atmosphere including a high temperature, a high humidity, a chemical, a generated toxic gas and the like because a biaxially oriented PPS film is stacked in the outermost layer of the seal film. However, the gas barrier properties of the gas barrier layer deteriorate by long-term use as similar to the seal film described above in items (3) and (4), thereby resulting in the reduction in the output of the solar cell module. Accordingly, the seal film cannot achieve a reliability of enabling a longer life of 20 to 30 years.

Patent Document 1: Japanese Patent Application Kokai Publication No. 2000-138387
Patent Document 2: Japanese Patent Application Kokai Publication No. 2002-100788
Patent Document 3: Japanese Patent Application Kokai Publication No. 2002-26354
Patent Document 4: Japanese Patent Application Kokai Publication No. 2003-31824
Patent Document 5: Japanese Patent Application Kokai Publication No. 2005-86104
Patent Document 6: Japanese Patent Application Kokai Publication No. Sho 55-35459

## DISCLOSURE OF INVENTION

## PROBLEMS TO BE SOLVED BY THE INVENTION

In consideration of the foregoing problems, an object of the present invention is to provide a seal film which solves a problem of the deterioration of the seal film due to external environment, and also to provide a solar cell module using the seal film. In the seal film, prevention of the gas barrier property deterioration due to long-term use that has been a problem with the prior art is achieved, combination of environmental resistance properties (heat resistance, hydrolysis resistance, weather resistance, chemical resistance, and the like) is well balanced, and thus markedly excellent long-term reliability is achieved.

## MEANS FOR SOLVING THE PROBLEMS

A seal film for solar cell module of the present invention has the following construction (1).

(1) The seal film for solar cell module includes: a resin film layer including a biaxially oriented film layer formed of a resin composition containing poly-p-phenylene sulfide as a major component; and a gas barrier layer formed of at least one selected from the group consisting of a metal, a metal oxide, an inorganic compound, and an organic compound. In the seal film for solar cell module, longitudinal and width direction heat shrink ratios at 150°C of the seal film for solar cell module are both within a range of -2.0% to +2.0%, and an absolute value of a difference between the longitudinal and width direction heat shrink ratios at 150°C is 2.0% or less.

More specifically, the seal film for solar cell module of the present invention preferably has any of the following constructions (2) to (4).

(2) In the seal film for solar cell module according to foregoing (1), a ratio (laminating ratio: $B/A \times 100$) of an overall thickness (B) of the biaxially oriented film layer to the thickness (A) of the seal film for solar cell module is 10% or more, the biaxially oriented film layer forming the seal film and being formed of the resin composition containing poly-p-phenylene sulfide as the major component.

(3) In the seal film for solar cell module according to the foregoing item (1) or (2), a high temperature volatile content of the biaxially oriented film formed of the resin composition containing poly-p-phenylene sulfide as the major component is 0.02% by mass or less.

(4) A seal film for solar cell module in which a weather resistant resin layer is stacked on at least one surface of the seal film for solar cell module according to any one of the foregoing items (1) to (3).

A solar cell module of the present invention also has the following construction (5).

(5) A solar cell module including the seal film for solar cell module according to any one of the foregoing items (1) to (4) disposed on at least one surface of the solar cell module.

## EFFECT OF THE INVENTION

According to the present invention, the seal film for solar cell module in which environmental resistance including heat resistance, hydrolysis resistance, weather resistance and chemical resistance (toxic-gas resistance) is improved and change with time in gas barrier property is effectively prevented. This is enabled by using a PPS film excelling in heat resistance, hydrolysis resistance and chemical resistance as the seal film, by controlling a heat dimensional change ratio of the seal film within a particular range, and by balancing heat dimensional change ratio characteristics in the longitudinal and width directions.

In the seal film for solar cell module of the present invention, deterioration due to external environment including a harsh high temperature, a high humidity, a generated toxic gas, ultra-violet light and the like is prevented, and prevention of the gas barrier property deterioration due to long-term use that has been a problem with the prior art is achieved. The seal film for solar cell module has well-balanced combination of environmental resistance properties including heat resistance, hydrolysis resistance, weather resistance and chemical resistance (resistance to deterioration by a toxic gas), and consequently achieves an excellent long-term reliability.

In addition, in the solar cell module using the seal film for solar cell module of the present invention, reduction in output due to penetration of water vapor can be significantly improved. The solar cell module is resistant to deterioration by hydrolysis, ultraviolet light and generated toxic gas, and thus excellent in environmental resistance. Furthermore, the solar cell module is excellent in lightweight properties and mechanical strength.

## BRIEF DESCRIPTION OF DRAWINGS

[Fig. 1] Fig. 1 is a diagram showing a basic construction of the seal film for solar cell module of the present invention.
[Fig. 2] Fig. 2 is a diagram showing an example of the construction of the solar cell module of the present invention.
[Fig. 3] Fig. 3 is a diagram showing an example of the construction of the seal film for solar cell module of the present invention provided with a weather resistance resin layer.
[Fig. 4] Fig. 4 is a diagram showing a stack construction of the seal film for solar cell module of the present invention manufactured according to an embodiment.

## EXPLANATION OF REFERENCE NUMERALS

| | |
|---|---|
| 1 | Front sheet layer |
| 2 | Filling adhesive resin |
| 3 | Solar cell element |
| 4 | Back sheet layer |
| 41 | Gas barrier layer |
| 41a | Silicon oxide film layer used as a gas barrier layer |
| 42 | Resin film layer |
| 42a | Polyphenylene sulfide film layer |
| 42b | Film layer other than polyphenylene sulfide film layer |
| 43 | Gas barrier layer supporting film |
| 44 | Weather resistant layer |

## BEST MODE FOR CARRYING OUT THE INVENTION

A basic construction of a seal film for solar cell module of the present invention is formed of two layers of a resin film layer 42 and a gas barrier layer 41 as shown in Fig. 1. In the present invention, a seal film for solar cell module refers to a seal film used as either or both of the front sheet and the back sheet provided on either sides of the solar cell module described below.

The seal film for solar cell module has a specific construction formed of a resin film layer 42 including: a biaxially oriented film layer formed of a resin composition containing poly-p-phenylene sulfide as a major component; and a gas barrier layer 41 formed of at least one selected from the group consisting of a metal, a metal oxide, an inorganic compound, and an organic compound. In the resin film layer 42, longitudinal and width direction heat shrink ratios at 150°C of the seal film for solar cell module are both within a range of -2.0% to +2.0%, and an absolute value of a difference between the longitudinal and width direction heat shrink ratios at 150°C is 2.0% or less.

The resin film layer 42 is formed of a plastic film, and has main roles to provide electrical insulation, to mechanically protect enclosed solar cell elements, and to take in light.

In the present invention, it is important that the resin film layer includes a biaxially oriented film layer formed of a resin composition containing PPS as a major component (hereinafter sometimes abbreviated to a PPS film) in order to provide resistance to harsh external environment.

The resin film layer 42 may further include a plastic film layer other than the PPS film. Examples of the plastic film other than the PPS film include a polyester-based film, which may be stretched or unstretched, such as polyethylene terephthalate (hereinafter sometimes abbreviated to PET) or polyethylene naphthalate (hereinafter sometimes abbreviated to PEN), an fluorine film, which may be stretched or unstretched, such as polytetrafluoroethylene (PTFE), a perfluoroalkoxy (PFA) resin formed of a copolymer of tetrafluoroethylene and perfluoro (alkyl vinyl ether), a copolymer of tetrafluoroethylene and hexafluoropropylene, a copolymer of tetrafluoroethylene, perfluoro (alkyl vinyl ether) and hexafluoropropylene (EPF), a copolymer of tetrafluoroethylene and ethylene or propylene (ETFE), polychlorotrifluoroethylene resin (PCTFE), a copolymer of ethylene and chlorotrifluoroethylene resin (ECTFE), vinylidene fluoride resin (PVDF), a vinyl fluoride resin (PVF), a olefin-based fluorine film, a nylon-based fluorine film, or the like. A single film of a PET film or a PEN film, and a laminated film using a PET film or a PEN film as some layers of the film are particularly preferable in consideration of a balance between processability, mechanical strength, weather resistance, price, and the like.

Fig. 1 shows a basic construction of the seal film of the present invention. As for the thickness in the basic construction of the seal film of the present invention, when the overall thickness of the seal film for solar cell module is designated as (A) and the thickness of the PPS layer is designated as (B), the laminating ratio (laminating ratio: (B/A $\times$ 100)) of the PPS film is preferably 10% or more, more preferably 15% or more. The thickness of the PPS film layer is made 10% or more relative to the overall thickness of the seal film because a better effect of controlling the deterioration of the seal film due to a harsh external environment including a high temperature, a high humidity, a generated gas, ultra-violet light and the like can be obtained. It is an object of the present invention to obtain the above effect. The higher ratio of the thickness of the PPS film layer enhances more the effect of the present invention. The upper limit of the ratio of the thickness of the PPS film layer is therefore up to near 100%. However, the higher ratio of the thickness of the PPS film layer sometimes causes the seal film to be brittle and to thereby tend to be split off. Therefore, in this respect, the upper limit is preferably 95%, more preferably 90%.

The PPS film layer may be formed of several separate laminated PPS film layers. Alternatively, the PPS film layer may of course be made of a single PPS film. In some cases, the PPS film is used as a base film of a gas barrier layer described below. Such a film is also included in the PPS film layer of the present invention. The thickness (A) of the seal film for solar cell module is the total of the thickness of the resin film layer and the thickness of the gas barrier layer. When the PPS film layer is formed of two or more laminated layers, the thickness of the PPS film layer (B) is the total of the thicknesses of these layers.

The gas barrier layer in the seal film of the present invention refers to a layer having barrier properties against water vapor and oxygen. To be specific, the gas barrier layer is formed of at least one selected from the group consisting of an inorganic compound, such as metal, metal oxide, silica or the like, and an organic compound, and can be formed by a conventionally known method including vapor deposition, sputtering, coating or the like.

For the gas barrier layer of the present invention, water vapor barrier properties are more important. The gas barrier layer of the present invention is a layer preferably achieving an initial value (value before an aging test) of water vapor permeability measured by a method based on JIS K7129-1992 B method (the same as a measurement method of the water vapor permeability of the seal film to be described later) of 2.0 g/m$^2$/24hr or less. A preferred construction composition of the gas barrier layer includes aluminum oxide and silicon oxide.

The gas barrier layer may be directly provided on the foregoing resin film layer by the abovementioned vapor deposition method and the like; alternatively, the gas barrier layer once provided on another film may be provided on the resin film with an adhesive. The latter method is generally used because of the low price. The foregoing another film is not particularly limited; however, in general, a PET, PEN, PPS, or fluorine-based film or the like is preferably used as the film. The thickness of these films is not particularly limited and preferably within a thickness range of 5 to 25 $\mu$m from the viewpoints of the processability and economy of the vapor deposition, sputtering, coating and the like.

In the present invention, poly-p-phenylene sulfide refers to a polymer preferably containing 90 mol% or more, more preferably 95 mol% or more of the PPS component and being formed of construction units represented by the following formula (1). The content of the PPS component less than 90 mol% causes crystallinity, thermal transition temperature and melting point of the polymer to be low. Consequently, advantages of a resin composition containing PPS as a major component such as heat resistance, hydrolysis resistance, mechanical properties and chemical resistance cannot sometimes successfully be exhibited.

[Chemical formula 1]

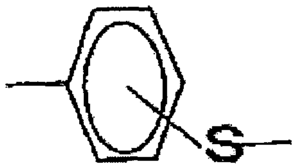

(1)

A unit containing other copolymerizable sulfide bond may be contained in the above PPS resin, as long as the amount of unit is less than 10 mol%, preferably less than 5 mol% relative to the repeated units. In this case, the construction units may be copolymerized by either a random type or a block type copolymerization method.

In the present invention, the resin composition containing PPS as a major component refers to a composition containing 60% by mass or more of PPS. If the content of PPS is less than 60% by mass, it is difficult to successfully exhibit the mechanical properties, heat resistance, hydrolysis resistance, moisture absorption dimension stability, chemical resistance and the like of a layer formed of the composition of the seal film for solar cell module of the present invention. As the remaining contents less than 40% by mass, the composition may contain additives such as a polymer other than PPS, an inorganic or organic filler, a lubricant, and a coloring agent. In addition, a melt viscosity of the PPS composition is preferably within a range of 100 to 50000 poise at 30°C and at a shear velocity of 200 $sec^{-1}$ because of the easiness of molding and film formation processing, and more preferably 500 to 20000 poise.

A biaxially oriented film formed of the PPS resin composition refers to a film formed by melt-extruding, biaxially extending and heat-treating a resin composition containing the aforementioned PPS as a major component and preferably has a thickness within a range of 5 to 300 μm from the viewpoint of processability, mechanical properties and environmental resistance properties. A PPS film containing additives within the above range and colored in white or black may be used.

A PPS film having a high temperature volatile content of 0.02% by mass or less is particularly preferable from the viewpoint of particularly important ultra-violet resistance among various kinds of weather resistance. The high temperature volatile content here refers to a difference between the volatile content (% by mass) generated from the PPS film at 250°C and the volatile content (% by mass) generated from the PPS film at 150°C and is a value determined by using the equation shown below. The PPS film having more than 0.02% by mass of the high temperature volatile content is not preferable because the film contains a large amount of impurities and tends to be changed in color to brown when irradiated by ultra-violet light and, generally, deterioration in the mechanical properties are fast.

•High temperature volatile content (% by mass) = {volatile content generated at 250°C (% by mass)} - {volatile content generated at 150°C (% by mass)}

In the present invention, a solar cell module refers to a system converting sunlight into electricity. An example of general model of the structure of the solar cell module is shown in Fig. 2. That is, the basic construction is formed of a front sheet layer 1, a filling adhesive resin layer 2, solar cell elements 3, a filling adhesive resin layer 2 and a back sheet layer 4 in this order from a sunlight incoming side. In some cases, the solar cell module is incorporated into a residential roof, mounted to a building or a fence or used in an electronic component. Such a solar cell module includes one which is called a day lighting type or a see-through type, allows sunlight to penetrate and is thus used in a window or sound barrier wall of a freeway and a railway. A flexible type is also practically used.

The front sheet layer refers to a layer provided to allow sunlight to efficiently penetrate and to protect the internal solar cell elements.

The filling adhesive resin layer is used for the purposes of adhesion and filling for accommodation and seal of the solar cell elements between the front sheet and the back sheet, and needs to have weather resistance, water resistance (hydrolysis resistance), transparency, adhesion properties, and the like. Examples suitably used for the filling adhesive resin layer include an ethylene-vinyl acetate copolymer resin (hereinafter sometimes abbreviated to EVA), polyvinyl butyral, ethylene-vinyl acetate partial oxide, a silicone resin, an ester-based resin, an olefin-based resin, and the like. EVA is most general.

The back sheet layer is used to protect the solar cell elements on the back surface side of the solar cell module and needs to have water vapor blocking performance, electrical insulation performance, mechanical properties, and the like. The back sheet includes a white type one reflecting sunlight incoming from the front sheet side for reuse of the sunlight, a type colored in black or the like in consideration of design, or a transparent type one allowing sunlight to also enter the module from the back sheet side. The present invention can be applied to all these types.

In the present invention, the seal film for solar cell module refers to a seal film used as both or one of the front sheet and the back sheet as described above and has a basic construction formed of two layers of a resin film layer and

a gas barrier layer as described above. The thickness of each of the front sheet and the back sheet is preferably within a range of 30 μm to 700 μm from the viewpoints of mechanical strength, electrical insulation properties and processability, and more preferably within a range of 35 μm to 500 μm. In the present invention, the thickness of the seal film for solar cell module is preferably within a range of 100 μm to 700 μm, more preferably 120 μm to 500 μm for the front sheet, and is preferably within a range of 30 μm to 400 μm, more preferably 35 μm to 300 μm for the back sheet.

In the present invention, it is important that the longitudinal direction and width direction heat shrink ratios at 150°C of the aforementioned seal film for solar cell module are both within a range of -2.0% to +2.0%, preferably -1.7% to +1.7%, more preferably -1.5% to +1.5%. Furthermore, it is important that the absolute value of the difference between the longitudinal and width direction heat shrink ratios at 150°C is controlled so as to be 2. 0% or less, preferably 1.5% or less.

That is, heat shrinkage is prevented as much as possible and the characteristics in the longitudinal and width directions are balanced as well as possible. The deterioration of the gas barrier properties of the seal film for solar cell module after a long time use can thereby be controlled to improve the reduction with time in the output of the solar cell module. This is the largest effect of the present invention.

Here, in the present invention, the heat shrink ratio refers to a value after treatment at 150°C for 30 minute measured based on a dimensional change measuring method of JIS C2151-1990 and represented by a minus sign for expansion and by a plus sign for shrinkage. In the present invention, the heat shrink ratio is determined by the value after treatment at 150°C for 30 minute because of the following reason. That is, the maximum temperature in the use environment of a solar cell module is usually about 100°C to 120°C. The processing temperature of the seal film and the temperature for processing such as the construction of the solar cell module are about 120°C to 180°C. Accordingly, the heat treatment condition of 150°C and 30 minute near the above use environment temperature and the above processing temperature is selected from the temperature conditions of the above JIS standards. If the seal film has a heat shrink ratio within a range specified according to the present invention under the heat treatment condition, the gas barrier properties do not deteriorate in actual use environment and processing. As a result, an excellent seal film for solar cell module can be formed.

If any one of the longitudinal direction and width direction heat shrink ratios is out of a range of -2.0% to +2.0%, the gas barrier properties significantly deteriorate with time. The output of the solar cell module consequently is to be out of the acceptable range of the output reduction with time. The above acceptable range is an object of the present invention. As a result, an object of the present invention cannot be achieved.

The cause for this is estimated to be as follows. That is, between a resin layer and a gas barrier layer formed of a vapor deposited overcoat layer of a metal oxide or the like which constructs the foregoing seal film for solar cell module of the present invention and between these layers and the filling adhesive resin layer to fix the solar cell elements by filling, the resin film layer repeats change in dimension due to shrinkage and expansion under a mount environment. Accordingly, stress is applied to the overcoat layer made of a hard metal oxide forming the gas barrier layer to thereby create cracks, resulting in the deterioration of water vapor barrier properties.

Furthermore, if the absolute value of a difference between longitudinal and width direction heat shrink ratios exceeds 2.0%, the same problem occurs. Consequently, an object of the present invention cannot be achieved. Therefore, the two requirements are most important in the present invention. The exceedance of the absolute value of a difference between heat shrink ratios beyond 2.0% refers to a case in which, for example, the seal film expands or shrinks excessively more in one of the longitudinal and width directions than in the other, or a case in which the seal film expands in one direction and shrinks in the other direction, and thus the difference between heat shrink ratios exceeds 2.0%. The reason why the same problem arises when the absolute value of a difference between the longitudinal and width direction heat shrink ratios exceeds 2.0% in the above manner is estimated to be as follows. A metal oxide constructing the gas barrier layer receives larger stress when the seal film unequally expands or shrinks in the longitudinal and width directions as compared to when the seal film equally expands or shrinks in the longitudinal and width directions. Note that, in the present invention, a difference between longitudinal and width direction heat shrink ratios refers to a value obtained by determining each of the longitudinal and width direction heat shrink ratios to two decimal places and by then rounding off the absolute value of the difference between the determined values to one decimal place.

Furthermore, the seal film for solar cell module of the present invention preferably has at least one surface laminated with a resin layer 44 having weather resistance (hereinafter referred to as weather resistant resin layer) as shown in Fig. 3 to provide good weather resistance. In particular, it is more preferable that the resin layer 44 having weather resistance be used on the front sheet side. Note that weather resistance refers to properties that deterioration by ultra-violet light irradiation hardly occurs. As the weather resistant resin layer, for example, a fluorine resin sheet, a polycarbonate resin and an acryl resin are particularly preferable from the viewpoints of weather resistance and transparency. The thickness of the weather resistant resin layer is preferably within a range of 5 μm to 100 μm from the viewpoints of transparency, processability, economy, and weight reduction. Here, as the fluorine resin sheet, the aforementioned sheet can be used. Resin sheets of a derivative or a modified resin of polycarbonate or acryl resin are included. As for the acryl resin, a benzotriazole-based monomer-copolymerized acryl resin is particularly preferable from the

viewpoints of weather resistance, transparency and thin film formation. The benzotriazole-based monomer-copolymerized acryl resin refers to a resin obtained by copolymerizing a benzotriazole-based reactive monomer and an acryl monomer, and may be in any form such as an organic solvent-soluble one, water-dispersed one and the like. The banzotriazole-based monomer may be a monomer having benzotriazole in basic skeleton and an unsaturated double bond, and not particularly limited. A preferred monomer is 2-(2,-hydroxy-5,-methacryloxyethylphenyl)-2H-benzotriazole. Acryl monomers usable for copolymerization with this monomer include alkyl acrylate, alkyl methacrylate (where the alkyl group is a methyl group, an ethyl group, a n-propyl group, an isopropyl group, a n-butyl group, an isobutyl group, a t-butyl group, a 2-ethylhexyl group, a lauryl group, a stearyl group, a cyclohexyl group or the like), a monomer having a crosslinkable functional group such as a monomer having a carboxyl group, a methylol group, an acid anhydride group, a sulfonate group, an amide group, a methylolized amide group, a methylolized amino group (including a substituted amino group), an alkylolized amino group, a hydroxyl group, an epoxy group or the like. Examples of the monomer having the above described functional group include acrylic acid, methacrylic acid, itaconic acid, maleic acid, fumaric acid, crotonic acid, vinylsulfonic acid, styrenesulfonic acid, acrylamide, methacrylamide, N-methylmethacrylamide, methylolized acrylamide, methylolized methacrylamide, diethylaminoethylvinylether, 2-aminoethylvinylether, 3-aminopropylvinylether, 2-aminobutylvinylether, dimethylaminoethyl methacrylate and monomers obtained by methylolizing the above amino groups, β-hydroxyethyl acrylate, β-hydroxyethyl methacrylate, β-hydroxypropyl acrylate, β-hydroxypropyl methacrylate, β-hydroxyvinyl ether, 5-hydroxypenthyl vinyl ether, 6-hydroxyhexyl vinyl ether, polyethylene glycol monoacrylate, polyethylene glycol monomethacrylate, glycidyl acrylate, glycidyl methacrylate and the like; however, the monomer having the above described functional group is not necessarily limited thereto. In addition to the above monomers, monomers such as acrylonitrile, methacrylonitrile, styrene, butyl vinyl ether, a monomer or dialkyl ester of maleic acid or itaconic acid, methyl vinyl ketone, vinyl chloride, vinylidene chloride, vinyl acetate, vinyl pyridine, vinyl pyrrolidone, alkoxysilane having a vinyl group, polyester having an unsaturated bond and the like may be used as a copolymerization component.

In the present invention, one or more kinds of the above acryl-base monomers may be copolymerized in any ratio. Methacrylate or styrene is preferably contained at a ratio of 50% by mass or more, more preferably 70% by mass or more, in an acryl component from the viewpoint of the hardness of the laminated film. A benzotriazole-based monomer and an acryl monomer are preferably copolymerized at a copolymerization ratio of the benzotriazole-based monomer of 10 to 70% by mass or less, more preferably 20 to 65% by mass or less, particularly preferably 25 to 60% by mass or less from the viewpoints of weather resistance, the adhesion properties of the weather resistant resin layer to the seal film for solar cell module and the durability of the weather resistant resin layer. The molecular weight of the copolymerization monomer is not particularly limited, and preferably 5000 or more, more preferably 10000 or more from the viewpoint of the durability of the weather resistant resin layer. A laminating thickness is not particularly limited, and preferably within a range of 0.3 to 10 μm from the viewpoints of weather resistance and blocking prevention.

A circuit may be formed of a metal layer, a conductive resin layer, a transparent conductive layer or the like on the surface of the seal film for solar cell module of the present invention.

Next, an example of a method of manufacturing the seal film for solar cell module of the present invention will be described.

Firstly, a method of producing a PPS film constructing the seal film for solar cell module of the present invention will be described.

The PPS is produced by a method in which alkaline sulfide and p-dichlorobenzene are reacted with each other in a polar solvent at a high temperature and a high pressure. In particular, sodium sulfide and p-dichlorobenzene are preferably reacted with each other in an amide-based polar solvent having a high boiling point such as N-methylpyrrolidone. In this case, it is particularly preferable that a so-called polymerization aid such as caustic alkali or a carboxylic acid salt of an alkali metal be added to control a polymerization degree and that reaction be carried out at 230 to 280°C. The pressure in a polymerization system and a polymerization time are suitably determined depending on the kind and amount of an aid to be used and a desired polymerization degree. The obtained polymer is further preferably washed by using water or an organic solvent containing no metal ion to remove a byproduct salt formed during polymerization and the polymerization aid.

Inert inorganic particles or the like are mixed with the PPS polymer thus obtained to produce a PPS resin composition. The mixing method is as follows. Both are mixed and blended by a mixer and the like. Thereafter, the mixture is pushed out in a gut shape while melt-extrusion-mixed by a known method typified by an extruder, and then cut into pellets. A mixture formed by melt-mixing an additive in a high concentration is once cut into pellets. Then, the pellets may be mixed with other pellets not containing the additive to dilute the concentration of the additive.

It is preferable that the PPS film constructing the resin film layer of the present invention contain a lower amount of impurities from the viewpoint of weather resistance (ultra-violet resistance). That is, the PPS film particularly preferably contains 0.02% or less by mass of a high temperature volatile content because the change in color by ultra-violet light and the deterioration of the mechanical properties to hardly occur. A method of reducing the high temperature volatile content is to dry a polyphenylene sulfide resin composition obtained in the above manner preferably under a reduced

pressure, more preferably under a reduced pressure of a vacuum degree of 0 to 50 mmHg, preferably at 120 to 200°C, more preferably 160°C to 195°C, and preferably for 3 hours or more, more preferably for 5 to 10 hours while being stirred by a mixer.

The above composition is further dried again under a reduced pressure, preferably at a vacuum degree of 0 to 50 mmHg, at 120°C to 170°C and for 1 hour or more. The amount of volatile content to be noted can be controlled within a targeted range by carrying out drying in two steps in the above manner. At this time, a difference obtained by subtracting the volatile content at 150°C from the volatile content at 250°C of the resin composition obtained by the above processes is made to be 0.3% by mass or less. The high temperature volatile content of the PPS film produced by melt-extruding, casting, biaxially stretching and heat-treating the resin composition as described below can be controlled to be 0.02% by mass or less.

Drying may be carried out in multi steps, that is, the resin composition is dried, then gradually cooled to a room temperature and dried again. Here, a drying temperature exceeding 200°C may lead to thermal deterioration of the polymer to generate a foreign matter, or cause problems in film formation such as solidification of the dried raw material and thickness variation and the like. Furthermore, when the temperature is less than 120°C, an effect of reducing a difference in the volatile content referred to in the present invention cannot be achieved. In addition, the polymerized powder raw material may directly be dried in multi steps by the above method. The high temperature volatile content to be noted can be controlled within a desired range by the following method as well as the above method.

The resin composition is obtained by the same method as described above. The resin composition is again supplied to an extruder having a vent hole. The resin composition is preferably dried under a reduced pressure, preferably under a reduced pressure of a vacuum degree of 0 to 50 mmHg, preferably at 120 to 200°C, more preferably at 160°C to 195°C, preferably for 3 hours or more, more preferably for 5 to 8 hours while being stirred by a mixer, and then again extruded. At this time, drying is more preferably carried out in two steps by the same method as described above. The high temperature volatile content can be reduced within a targeted range by carrying out extrusion in multiple steps in the above manner.

The PPS obtained above is then formed into a biaxially stretched film to obtain a biaxially oriented layer of the PPS. The PPS resin composition obtained above is supplied to a melt-extruder typified by an extruder. The molten polymer is then continuously extruded from a slit-shaped die such as a T die and thereafter forcibly cooled to obtain an unoriented and uncrystallized sheet. As for such a forced cooling means, a method in which the molten polymer is cast on a cooled metal drum to be cooled to a glass transition temperature (hereinafter sometimes abbreviated to Tg) or less of the PPS for solidification is most preferable because the thickness irregularity is small.

The sheet obtained in such a manner is biaxially stretched. A sequential biaxial stretching method and a simultaneous biaxial stretching method including a tenter method and a tubular method can be used as the stretching method. Conditions under which the sheet is biaxially stretched are somewhat different depending on the properties of the polymer to be used and the stretching method. In the sequential biaxial stretching method, it is preferable that stretching temperatures of both the longitudinal direction (hereinafter sometimes abbreviated to MD) and the width direction (hereinafter sometimes abbreviated to TD) of the film be in a range of 85 to 105°C, stretching magnifications in both the longitudinal direction and the width direction be 1.5 to 4.5 and a MD/TD stretching magnification ratio (stretching magnification in MD/stretching magnification in TD) be in a range of 0.6 to 1.3, from the viewpoints of the thickness irregularity of the film, control of molecular orientation and the balance of heat shrink ratios.

Furthermore, it is particularly preferable that orientation factors OF be controlled to be 0.33 to 0.75 in both an edge direction and an end direction and the OF ratio between both directions (edge direction/end direction) be in a range of preferably 0.7 to 1.4, more preferably 0.8 to 1.3 from the viewpoints of the mechanical properties deterioration by the environment and the balance of heat shrink ratios in both axes referred to in the present invention. Here, the orientation factor OF measured in the edge direction (or end direction) refers to a value defined by a ratio $I_{\varphi=30^\circ}/I_{\varphi=0^\circ}$ between a value of the photographic density ($I_{\varphi=0^\circ}$) obtained by taking an X-ray plate photograph with X-ray incident from the direction parallel to the film surface and also parallel to the width direction (or longitudinal direction), and scanning a diffraction ring from the (200) plane of a PPS crystal with a microdensitometer in the radial direction on the equator line and a value of the photographic density ($I_{\varphi=30^\circ}$) obtained by the scanning from the 30° direction.

The thus obtained biaxially stretched PPS film is preferably further heat-treated under a limited shrinkage condition of a relaxation rate of 15% or less in the film width direction preferably at a heat treatment temperature of 240°C to the melting point of the polymer, more preferably at 250°C to the melting point of the polymer for a heat treatment time in a range of 1 to 60 seconds to balance heat shrink ratios in both axial directions (MD and TD) and to control a 150°C heat shrink ratio of the present invention within a range of -2.0% to +2.0%.

The film balanced in the molecular orientation factor OF in the MD and the TD is particularly preferably further subjected to a low-tension relax treatment (hereinafter sometimes referred to as "post-annealing treatment") while being heated, from the viewpoints of achieving reduction of the heat shrink ratio of the PPS film and balance of the heat shrink ratios in the MD and the TD. As the post-annealing method, a known method such as a hot-air oven method and a roll method can be used. The hot-air oven method allowing the low-tension relax treatment at a temperature of 120 to 200°C

for about 1 to 30 minutes is particularly preferable because both reduction in heat yield and flatness can be satisfied.

The followings are important to obtain the seal film for solar cell module of the present invention. In order to control the reduction in heat shrink ratio and the balancing in the MD and the TD of the seal film for solar cell module, both the longitudinal and width direction heat shrink ratios at 150°C of the PPS film are controlled within a range of -2.5% to +2.5% during the film formation process, the absolute value of the difference between the longitudinal direction and width direction heat shrink ratios at 150°C of the PPS film are controlled to 2% or less, and control of the final heat shrink ratios of the PPS film is performed by a post-annealing process.

Next, a biaxially stretched film made of polyethylene terephthalate will then be described as an example of a film other then the PPS film constructing the resin film layer of the present invention. Polyethylene terephthalate being a polymer can be obtained through an ester exchanging reaction between terephthalic acid or the derivative thereof and ethylene glycol performed by using a conventionally known method. A conventionally known reaction catalyst and anti-coloring agent can be used. Examples of the reaction catalyst includes an alkali metal compound, an alkaline earth metal compound, a zinc compound, a lead compound, a manganese compound, a cobalt compound, an aluminum compound, an antimony compound and a titanium compound. Examples of the anti-coloring agent include a phosphorus compound and the like. An antimony compound, a germanium compound or a titanium compound is preferably added as a polymerization catalyst generally at any step before the completion of the production of PET. When taking a germanium compound as an example, examples of such a method include a method in which a germanium compound powder is directly added and a method in which a germanium compound in a glycol component being a raw material of PET is dissolved and added as disclosed in Japanese Patent Application Koukoku Publication No. Sho 54-22234. The intrinsic viscosity [η] of the PET in a range of 0.6 to 1.2 is preferable from the viewpoints of the mechanical strength, the moisture heat resistance and the like. To control the intrinsic viscosity [η] within the above range, a method of a so-called solid phase polymerization in which the obtained polymer having an intrinsic viscosity [η] of 0.6 or less is heated at a temperature at a range of 190°C to less than the melting point of the PET at a reduced pressure or under a flow of an inert gas such as nitrogen gas is preferably used. The method can increase the intrinsic viscosity without increasing the amount of a terminal carboxyl group of the PET.

The same melt extrusion method and stretching method as those described above for the PPS film can be used to form the polymer into a biaxially stretched film. Any condition can be selected as the condition of the above case from stretching temperatures of the Tg of the polymer or more to the Tg + 100°C. A temperature range of 80 to 170°C is generally preferable from the viewpoints of the physical properties of the finally obtained film and productivity thereof.

Stretching is preferably performed under a condition of stretching magnifications in a range of 1. 6- to 5.0-fold in both the longitudinal direction and the width direction. It is preferable that the stretching magnifications in both the longitudinal direction and the width direction be in a range of 2- to 4.5-fold and the stretching ratio (longitudinal direction magnification/width direction magnification) be in a range of 0.75 to 1.5, from the viewpoints of the reduction in heat yield, the balancing of the longitudinal direction and width direction heat shrink ratios and the thickness irregularity of the film which are an object of the present invention.

In addition, a stretching rate is preferably in a range of 1000 to 200000%/minute. Further, heat treatment is performed. The heat treatment can be continuously performed in a heat treatment chamber following a tenter to perform stretch in the width direction. Alternatively, the heat treatment can be performed by heating in another oven or by a heating roll. The most preferable method is a tenter method in which the molecular orientation balance in the longitudinal direction and the width direction is maintained by constraint (fixation) in the longitudinal direction and the width direction from the viewpoints of the reduction in heat yield and the balancing of longitudinal direction and width direction heat shrink ratios which are an object of the present invention. The heat treatment is preferably performed under a condition of preferably at a temperature of 150 to 245°C, more preferably at 170 to 235°C for a heating time of 1 to 60 seconds under a limited shrinkage condition of a relaxation rate in the width direction of preferably 12% or less, more preferably of 10% or less from the viewpoints of the reduction in heat shrink ratio and the balancing of longitudinal direction and width direction heat shrink ratios.

It is particularly preferable that a film having molecular orientation factors in the longitudinal direction and the width direction balanced in the above manner be further post-annealed from the viewpoints of the reduction in heat shrink ratio of the polyester film and the balancing of longitudinal and width direction heat shrink ratios thereof. A known method such as a hot-air oven method and a roll method can be used to perform post-annealing. The hot-air oven method allowing post-annealing at a temperature of 120 to 200°C for approximately 1 to 30 minutes is particularly preferable from the viewpoints of the reduction in heat shrink ratio and of flatness.

In addition, in order to control the reduction in the heat shrink ratio of the seal film for solar cell module and the balancing of longitudinal and width direction heat shrink ratios, as in the case of the PPS film, both the longitudinal and width direction heat shrink ratios at 150°C of the polyester film are controlled within a range of -2.5% to +2.5%, the absolute value of the difference between the longitudinal and width direction heat shrink ratios at 150°C of the polyester film are controlled to 2% or less during the film formation process, and control of the final heat shrink ratios of the polyester film is performed by a post-annealing process. Such control is preferable because an object of the present invention is

easily achieved.

A biaxially stretched polyethylene naphthalate film will be described as a next example of other plastic film. Polyethylene naphthalate is produced by a known method in which naphthalene-2,6-dicarboxylic acid or a functional derivative thereof such as methyl naphthalene-2,6-dicarboxylate and ethylene glycol are polycondensed in the presence of a catalyst under suitable reaction conditions. An intrinsic viscosity, which corresponds to the polymerization degree of the polymer, is preferably 0.5 or more from the viewpoints of mechanical properties, hydrolysis resistance, heat resistance and weather resistance. As a method of increasing the intrinsic viscosity, a heat treatment or solid phase polymerization can be performed under a reduced pressure or an inert gas atmosphere at a temperature of the melting point of the polymer or less.

To form the PEN obtained in the above manner into biaxially stretched film, the polymer is dried, molded in a sheet-form at a temperature in a range of 280 to 320°C by using a melt extruder, and cast at a temperature of the Tg or less. That is, a biaxially stretched film can be obtained by the same method as that for the PET film described above. With respect to the stretching conditions in the above case, stretching magnifications in both the longitudinal direction and the width direction are preferably in a range of 2- to 10-fold at a temperature of 120°C to 170°C and a stretching ratio (longitudinal direction magnification/width direction magnification) is preferably in a range of 0.5 to 2.0 from the viewpoints of film thickness irregularity and the balancing of longitudinal and width direction heat shrink ratios . This film is heat-treated by the same method as that for the above PET-BO. The conditions of the treatment are preferably at a temperature of 200 to 265°C, more preferably 220 to 260°C and under a limited shrinkage condition of a relaxation rate of 7% or less in the width direction for a period of 1 to 180 seconds. The obtained film is particularly preferably further post-annealed by a conventionally known method such as a hot-air oven method and a roll method from the viewpoints of the reduction in heat shrink ratio and the balancing in the longitudinal direction and the width direction which are important requirement of the seal film of the present invention. The annealing process is effectively performed under conditions of a temperature of 120 to 220°C for 0.5 to 30 minutes.

A fluorine-based film, a polyimide film and the like can also be used. When the heat shrink ratio of a seal film for solar cell module produced by processing any of these films is out of the range of the present invention, post-annealing described with the above PET film and the PEN film can be performed to make the heat shrink ratios of the seal film for solar cell module finally obtained be within the range of the present invention. Note that these films may be colored in white, black or the like, or may have transparency.

For each of the films to be stacked, both MD and TD heat shrink ratios at 150°C are controlled within a range of -2.0% to +2.0% and the absolute value of a difference between heat shrink ratios of both axes in the MD and the TD is controlled to 2.0% or less in the above manner before lamination. Such control makes it possible to control the heat shrink ratios at 150°C of the seal film for solar cell module of the present invention and the balance of the heat shrink ratios of both axes within the range of the present invention. Accordingly, prevention of reduction in the gas barrier properties due to long term use, which is one object of the present invention, can be achieved, and thus long-term reliability can be improved.

The resin film layer according to the present invention has a construction in which, for example, the foregoing PPS film and the foregoing PET film are stacked. As for a laminating method, a method in which a conventionally known solution of a urethane-based, polyester-based, acryl-based, or epoxy-based adhesive or the like is applied by a known method such as a gravure roll coater, a reverse coater, a die coater or the like, and then dried, and lamination is carried out at a temperature of 50 to 120°C by a heat roll press method or the like can be employed. Further, the adhesive is cured as necessary. The present invention, of course, includes adhesive-free lamination such as heat fusion lamination after a surface treatment such as a plasma treatment.

Next, the gas barrier layer according to the present invention can be formed as follows. A film made of, for example, one or a mixture of metal oxides, such as aluminum oxide, silicon oxide, magnesium oxide, tin oxide or titanium oxide, is formed on at least one surface of a film, such as a polyester film including a PPS film, a PET film, a polyethylene naphthalate film or the like or a fluorine-based film, by a conventionally known vacuum deposition method or sputtering method. The gas barrier film may, of course, be formed by laminating multiple layers of the same or different kinds of metal oxide layers. In this case, the thickness of the gas barrier layer is generally set within a range of 100 to 2000 Å. A conventionally known surface treatment for the purpose of easy adhesion is also rather preferably performed on a surface of the above film before providing the gas barrier layer. With respect to the above film provided with the gas barrier layer, it is particularly preferable that the heat shrink ratios at 150°C in both the MD and the TD be controlled within a range of -2.0% to +2.0% by the foregoing method, and the absolute value of a difference between the heat shrink ratios of both axes in the MD and the TD be to 2.0% or less from the viewpoint of the life extension of the gas barrier properties, which is an object of the present invention. In addition, the above gas barrier layer may, of course, directly be provided on the resin film layer of the present invention.

Next, the seal film for solar cell module of the present invention is a film formed by laminating the gas barrier layer on at least one surface of the resin film layer obtained above. The gas barrier layer can be formed directly on the resin film layer by a vacuum deposition method or a sputtering method by use of an inorganic compound such as a

metal oxide or the like as in the foregoing manner. In addition, a film (hereinafter referred to as a gas barrier layer supporting film) obtained by once laminating the gas barrier layer on a film layer can be stacked on the resin film layer. In this case, a conventionally known solution of an adhesive such as a urethane-based, polyester-based, acryl-based or epoxy-based adhesive or the like is applied on a surface of the gas barrier layer supporting film layer or the resin film layer by a conventionally known method such as a gravure roll coater, a reverse coater, a die coater or the like, and dried. Then, the gas barrier layer supporting film layer and the resin film layer are stacked at a temperature of 50 to 120°C by a method such as a heat roll press method. At this time, the gas barrier layer may face either surface in the laminated gas barrier layer supporting film.

In addition, when the weather resistant layer referred to in the present invention is stacked, the layer can be stacked on at least one surface of the foregoing seal film with the above used adhesive layer by the foregoing method, or can be stacked by applying a weather resistant resin solution by a conventionally known coating method.

Here, it is preferable that the laminating ratio of the total thickness (B) μm of the PPS film in the seal film be 10% or more relative to the total thickness (A) μm of the seal film obtained above, because the environmental resistance (heat resistance, hydrolysis resistance, weather resistance, toxic gas resistance and the like) of the seal film for solar cell module can be maintained over a long period. That is, an effect of maintaining the environmental resistance of the seal film for solar cell module by the PPS film is thus exhibited. The laminating ratio of 10% or less sometimes results in deterioration in the environmental resistance of the seal film for solar cell module. The PPS film may be stacked in one or several layers.

A method of manufacturing the solar cell module of the present invention will be described.

The solar cell module of the present invention is constructed in, for example, a form shown in Fig. 2. The solar cell module can be manufactured by preparing, for example, a transparent glass plate as the front sheet layer, by preparing the seal film layer obtained above as the back sheet layer and by then laminating the front sheet and the seal film on the either side of the solar cell elements with a filling adhesive resin layer such as EVA layer having a thickness of 100 to 1000 μm interposed between the front sheet and the seal film.

In the present invention, the seal film of the present invention can be used on the front layer side in the foregoing construction to reduce the weight. In this case, the seal film with a weather resistant resin layer 44 stacked therein as shown in Fig. 3 is preferably used. In addition, it is more preferable that the weather resistant resin layer side be used on the sunlight incoming side. The seal film used as the back sheet may be of transparent type or be colored in white and the like.

Here, any of the conventionally known various methods can be used as a laminating method. A vacuum lamination method is preferable because drawbacks such as wrinkles, air bubbles and the like are less likely to occur, and thus the layers can be uniformly stacked. A laminating temperature may generally be in a range of 100 to 180°C.

A lead wire serving for taking out electricity is further provided and fixed by a jacket member to obtain the solar cell module of the present invention.

## EXAMPLES

Examples will be shown below to describe the present invention in greater detail. Firstly, evaluation methods and evaluation standards of various characteristics of seal films for solar cell module to be obtained in each Example or each Comparative Example will be described.

(1) Heat shrink ratio at 150°C (dimensional change ratio at 150°C)

The heat shrink ratio is a value measured at 150°C after 30-minute period on the basis of JIS C2151-1990. The length of a sample is 200 mm. The value is expressed in percentage (%) (where a plus sign means shrinkage, and a minus sign means expansion) by using the following calculation formula. The longitudinal direction is expressed by MD and the width direction is expressed by TD. Five samples were used for each of the Examples and Comparative Examples. The average value of the values of the samples is considered as a heating shrinkage ratio for each of the Examples and the Comparative Examples.

Heat shrink ratio at 150°C =( (sample length at a room temperature) - (sample length after aging at 150°C for 30 minutes))/(sample length at a room temperature) × 100(%)

(2) Balance of heat shrink ratios

The difference between longitudinal and width direction heat shrink ratios determined by the method shown in the foregoing item (1) is calculated and expressed as an absolute value.

(3) Laminating ratio (A/B)

The cross-section of the seal film for solar cell module was observed with a 10- to 200-magnification optical microscope and photographed. Then, the dimension of the photographed cross-section was actually measured to determine the laminating ratio ($(A/B) \times 100$), and then the laminating ratio was expressed in percentage (%) . The value is expressed by an average of the measurements obtained by measuring the seal film in three different places. As for B layer, a total thickness of only the film layers of the seal film is used. For each of the Examples and the Comparative Examples, three samples were used. The thicknesses of three portions were measured per sample. The average value of the values measured in a total of nine portions is considered as the laminating ratio of the corresponding one of the Examples and the Comparative Examples.

(4) High temperature volatile content

Gas generated when a sample is heated by a purge and trap method was collected in an organic component absorption tube (ORBO-100) and an inorganic component absorption tube (ORBO-52) . The organic components were eluted by a solvent desorption method and measured by gas chromatography. The inorganic components were eluted by a solvent desorption method and measured by ion chromatography.
The amount of the sample was as follows. Heating was performed under the following conditions.

- Sample: 0.5 g to 3.0 g of a polyphenylene sulfide resin composition or a polyphenylene sulfide film
- Heating temperature: 250°C, 150°C
- Heating atmosphere: in an air flow (100 ml/minute)
- Heating time: 1 hour

A high temperature volatile content (% by mass) was determined from the above volatile contents at 250°C and at 150°C by using the following formula.

- High temperature volatile content (% by mass) = {volatile content generated at 250°C (% by mass)} - {(volatile content generated at 150°C (% by mass)}

Two (two sheets of) samples were used for each of the Examples and the Comparative Examples. The average value of the two samples was considered as the high temperature volatile content for the corresponding one of the Examples and the Comparative Examples.

(5) Orientation factor OF

PPS films were taken out for use as a sample. The samples were aligned in a direction, and then formed into strips with a thickness of 1 mm, a width of 1 mm and a length of 10 mm (a 5% amyl acetate solution is used to fix the films during the formation). An X-ray was irradiated (in edge and end directions) along the surface of the film to take a plate photograph.
A D-3F type X-ray generator available from Rigaku Corporation was used. A Cu-Ka radiation filtered by a Ni filter at 40 kV-20 mmA was used as an X-ray source. A distance between the sample and the film is 41 mm. A KODAK non-screen type film was used. A multiple exposure (15 minutes and 30 minutes) method was employed.
Next, an intensity of a (200) peak on a plate photograph was then determined by scanning a densitometer from the center of the photograph in a radial direction at $\varphi=0°$ (on the equator line), 10°, 20° and 30° to read the photographic density. The orientation factor OF of each of the samples was defined as follows.

$$\bullet \text{ Orientation factor OF} = I_{\varphi=30^\circ}/I_{\varphi=0^\circ}$$

Where $I_{\varphi=30^\circ}$ is the maximum intensity in 30° scanning, and $I_{\varphi=0^\circ}$ was the maximum intensity in scanning on the equator line. Note that, the average value of the intensities at φ=0° and φ=180° was used as $I_{\varphi=0^\circ}$. The average value of the intensities at φ=30° and φ=150° was used as $I_{\varphi=30^\circ}$.
Here, the measuring conditions of the densitometer were as follows.
Measuring equipment used was SAKURA MICRODENSITOMETER model PDM-5 TYPE A available from Konishiroku Photo Industry Co., Ltd. A measured concentration range was 0.0 to 4.0 D (equivalent to 4 $\mu m^2$ of minimum measurement area). An optical magnification of 100, a slit width of 1 μm and a height of 10 μm was used. A film transferring speed was 50 μm/second. A chart speed was 1 mm/second.
Two samples were used for each of the Examples and Comparative Examples. The average value of the two samples was considered as the orientation factor OF of the corresponding one of the Examples and the Comparative Examples.

(6) Durability of a gas barrier performance (water vapor permeability)

A durability test of a water vapor permeability was performed by aging a seal film (30 cm × 30 cm) to be measured for 2000 hours in an atmosphere at 85°C and at 93%RH while sandwiching the four sides of the seal film on the both surfaces by metal plates with a thickness of 2 mm to fix seal film and applying constant tension to the seal film by applying a load of 1 kg on the four sides. To be specific, the evaluation was performed by measuring water vapor permeabilities before and after the above aging on the basis of the JIS K7129-1992 B method. The measurement conditions were a temperature of 40°C and a humidity of 90%RH.
When an initial water vapor permeability was controlled to 0.5 $g/m^2$/24hours or less, the penetration rate was evaluated after the above aging. The results are evaluated by the following standards. If the water vapor permeability was less than 6.25 $g/m^2$/24hours (V (very good) or G (good)), change was small enough. Thus, such a water vapor permeability was judged as acceptable.

V (very good): Water vapor permeability was less than 5 $g/m^2$/24hours.
G (good) : Water vapor permeability was 5 $g/m^2$/24hours or more to less than 6.25 $g/m^2$/24hours.
P (poor): Water vapor permeability was 6.25 $g/m^2$/24hours or more.

(7) Hydrolysis resistance of the seal film

The hydrolysis resistance of the seal film was evaluated by the reduction degree in break strength of the seal film. The durability (strength maintaining properties) of the seal film under a high humidity condition was tested by aging 80 mm × 200 mm-sized seal film to be measured, in which a cut with a width of 10 mm (and a length of 150 mm) was made in advance so that a tensile strength can be measured, in an atmosphere of 85°C and 93%RH for 2000 hours. To be specific, break strengths before and after the above aging was measured on the basis of JIS C2151-1990. Evaluation was performed by comparing ratios (retention ratio) calculated by the following formula. Five films were used for evaluation for each of the Examples and Comparative Examples. The average retention ratio of the five sheets was evaluated on the basis of the following standards. If the retention ratio was 40% or more (V (very good) or G (good)), the change was small enough. Thus such a retention ratio was judged as acceptable.

• Break strength retention ratio = (break strength after the aging test)/(break strength before the aging test) × 100

V (very good) : The break strength retention ratio was 50% or more.
G (good): The break strength retention ratio was 40% or more to less than 50%.
P (poor) : The break strength retention ratio was less than 40%.

(8) Ultra-violet light resistance (change in break strength) of the seal film (weather resistance A)

An acceleration tester I-SUPER UW TESTER was used to repeat the cycle described below 5 times. The break strength was measured by the same method as that in the above (7) to determine the retention ratio and to then comparatively evaluate the determined values. Five films were used to perform evaluation for each of the Examples and

Comparative Examples. The average retention ratio of the five films was evaluated on the basis of the following standards. If the retention ratio was 30% or more (V (very good) or G (good)), the change was small enough. Thus the retention ratio was judged as acceptable.
1 cycle: After irradiation with ultra-violet light for 8 hours in an atmosphere at a temperature of 60°C and at a humidity of 50%RH, aging processing was performed for 4 hours under a dew condensation state (at a temperature of 35°C and at a humidity of 100%RH).

V (very good) : The break strength retention ratio was 40% or more.
G (good): The break strength retention ratio was 30% or more to less than 40%.
P (poor) : The break strength retention ratio was less than 30%.

(9) Ultra-violet resistance of the seal film (change in color tone of a film) (weather resistance B)

The color tone of the PPS film was observed in the above test of the weather resistance A to perform rating on four criteria on the basis of the following standard. When the rating was E (excellent), V (very good) or G (good), the seal film was judged as acceptable.

E (excellent): a state with little change in color tone due to aging
V (very good) : a state with a little change in color tone due to aging
G (good) : a state where change in color tone due to aging was partial blackish browning
P (poor) : a state where change in color tone due to aging was almost entire blackish browning

(10) Heat resistance of a seal film

Heat resistance of the seal film was evaluated by a reduction degree of the break strength of the seal film. A seal film was cut out in a size of 10 mm × 200 mm. A set of five strips was aged at 150°C in a hot-air oven for 1000 hours. The break strength was measured by the same method as that in the above (7) to determine the retention ratio and to then comparatively evaluate the determined values. Five strips were used to perform evaluation for each of the Examples and Comparative Examples. The average retention ratio of the five strips was evaluated on the basis of the following standards. When the retention ratio was 50% or more (V (very good) or G (good)), the seal film is acceptable.

V (very good) : The break strength retention ratio was 60% or more.
G (good): The break strength retention ratio was 50% or more to less than 60%.
P (poor) : The break strength retention ratio was less than 50%.

(11) Toxic-gas resistance of the seal film

Toxic-gas resistance of the seal film was evaluated by the reduction degree of the break strength of the seal film. A seal film was sampled in the same manner as in the above test of (10). The sample was put in a 500-cc autoclave containing 10 cc of ammonia water and aged at 50°C for 100 hours. The break strength was measured by the same method as that in the above (7) to determine the retention ratio and to then comparatively evaluate the determined values. Five samples were used to perform evaluation for each of the Examples and Comparative Examples. The average retention ratio of the five samples was evaluated on the basis of the following standards. When the retention ratio was 30% or more (V (very good) or G (good)), the change is small enough. Thus, the film was judged as acceptable.

V (very good) : The break strength retention ratio was 40% or more.
G (good): The break strength retention ratio was 30% or more to less than 40%.
P (poor) : The break strength retention ratio was less than 30%.

(12) Overall evaluation of the long-term durability of the seal film (Overall evaluation)

The above test results of the seal film were evaluated on the basis of each evaluation standard. The following standards were used for overall evaluation.

V (very good): a seal film achieving E (excellent) or V (very good) in all test items
G (good) : a seal film achieving G (good) in all test items or in some test items and no P (poor)
P (poor) : a seal film getting P (poor) in all test items or in some test items

(13) Evaluation of the output of a solar cell module

An environmental test was performed on the solar cell module on the basis of JIS C8917-1998. Outputs of photovoltaic power before and after the test were measured and expressed in the following output reduction ratio (%) . The output reduction ratio was evaluated on the basis of the following standards. When the output reduction ratio was V (very good) or G (good), the solar cell module is acceptable.

Output reduction ratio = (photovoltaic power value before the test - photovoltaic power value after the test)/(photovoltaic power value before the test) × 100 (%)

V (very good): The output reduction ratio was less than 7%.
G (good): The output reduction ratio was 7% or more to less than 10%.
P (poor): The output reduction ratio was 10% or more.

EXAMPLE 1

(1) Polymerization of PPS

An autoclave was charged with 32 kg (250 mol, containing 40% by mass of crystal water) of sodium sulfide, 100 g of sodium hydroxide, 36.1 kg (250 mol) of sodium benzoate and 79.2 kg of N-methyl-2-pyrrolidone (hereinafter abbreviated to NMP). Then, the temperature was gradually raised to 205°C with stirring to remove 7.0 liters of a distillate including 6.9 kg of water. To the residual mixture, 37.5 kg (255 mol) of 1, 4-dichlorobenzene (herein after abbreviated to DCB) and 20 kg of NMP were added and polymerization was performed at 250°C for 5 hours. The obtained reaction product was washed eight times alternately with hot ion-exchanged water and NMP, and dried at 80°C for 24 hours in a vacuum drier. The melt viscosity, glass transition temperature and melting point of the obtained PPS powder polymer were 4100 poise, 90°C and 285°C, respectively.

(2) Preparation of a PPS resin composition

Calcium carbonate powder having an average diameter of 1 μm was added by 1% to the PPS powder obtained in the above item (1). The mixture was then mixed with a Henschel mixer, subsequently extruded on a gut at a temperature of 320°C with a 30-mmφ biaxial extruder, cooled in water, and then cut short to form pellets of a PPS resin composition. The obtained PPS resin composition is designated as PPS-1.

(3) Drying the PPS resin composition

The poly-p-phenyl sulfide resin composition obtained in the above item (2) was dried for 7 hours at 180°C and at a reduced pressure of 10 mmHg while being mixed with a mixer, and then further dried for 5 hours at 160°C and 10 mmHg. The difference (high temperature volatile content) obtained by subtracting the volatile content at 150°C of the obtained poly-p-phenyl sulfide resin composition from the volatile content at 250°C thereof was 0.15% by mass.

(4) Production of a biaxially oriented PPS film

The dried pellets of the above item (3) were supplied to a 90-mmφ mono-axial extruder, melted at a temperature of 320 °C, extruded through a T die on a 300-mm slit, and cast to a mirror surface metallic drum having a surface temperature of 30°C to obtain an unstretched PPS sheet with a thickness of 350 μm. The sheet was introduced to a longitudinal stretcher constructed of a group of rolls and longitudinally stretched at a magnification of 3.7-fold at a temperature of 98°C. Thereafter, the mono-axially stretched film was introduced to a transverse stretcher (tenter), stretched in a width direction at a stretching temperature of 98°C and at a stretching magnification of 3.5-fold, and heat-treated at a temperature of 270°C for 10 seconds in a subsequent heat treatment chamber. The sheet was further subjected to a limited shrinkage with a relaxation rate of 10% in the width direction performed with the same tenter to obtain a biaxially stretched PPS film with a thickness of 25 μm. The orientation factor OF of the film was 0.40 in an edge direction and 0.44 in an end direction. The high temperature volatile content was 0.016% by mass. The film was further

passed through a coater drier at a temperature of 150°C for a 3-minute post-annealing at such a low tension that the flatness does not deteriorate. The heat shrink ratio at 150°C in the MD was +0.7% and the heat shrink ratio in the TD was +0.2%. A biaxially oriented PPS film was obtained. This film is designated as PPS-F-1. Both surfaces of the film were subjected to a corona discharge treatment at 6000 J/$m^2$ for the purpose of facilitating adhesion.

(5) Preparation of a resin film layer

(a) Production of a PET film

With 100 parts (by mass, the same shall apply hereinafter) of dimethyl terephthalate, 64 parts of ethylene glycol was mixed. In addition, 0.06 parts of magnesium acetate and 0.03 parts of antimony trioxide were added as a catalyst to the mixture. Then, an ester exchange reaction was performed while the temperature was raised to a range from 150°C to 235°C.
After 0.02 parts of trimethyl phosphate was added to the reaction product, the product was gradually heated and then polymerized at a temperature of 285°C under a reduced pressure for 3 hours. The intrinsic viscosity [η] of the obtained polyethylene terephthalate (PET) was 0.57. This polymer was cut into a form of a chip with a length of 4 mm.
The thus obtained PET having an intrinsic viscosity [η] of 0.57 was put in rotary heating vacuum equipment (rotary drier) under conditions of a temperature of 220°C and a vacuum degree of 0.5 mmHg , and then heated for 20 hours with stirring. The intrinsic viscosity of the thus obtained PET was 0.75. The PET was mixed, by stirring with a mixer, with a final amount of 0.1% by mass of master chips containing 10% by mass of silica (having a particle diameter of 0.3 μm). Then, the mixture was vacuum-dried at a temperature of 180°C and a vacuum degree of 0.5 mmHg for 3 hours, put in a melt extruder having a diameter of 90 mm, and electrostatically firmly attached to a cooling drum being held at 25°C to be cast. The extruding temperature was 270 to 290°C. The thickness of the obtained sheet was 1 mm. The sheet was stretched by 3.0-fold at a temperature of 90°C in the longitudinal direction of the film by a sequential biaxial stretching method. The film was subsequently supplied to a subsequent tenter, and then stretched by 3.0-fold at a temperature of 95°C in the width direction. The sheet was thereafter further heat-treated at a temperature of 220°C in the same tenter and subjected to a limited shrinkage with a relaxation rate of 5% in the width direction. The PET film thus obtained was passed through a roll transfer type coater drier for a 5-minute post-annealing at a temperature of 170°C while tension was suitably being reduced. The thickness of the film thus obtained was 100 μm (designated as PET-F-1). The heat shrink ratios of the film at 150°C in the MD and the TD were +0.5% and -0.02%, respectively.

(b) Production of a resin film layer

The PPS-F-1 and the PET-F-1 obtained in the above process were stacked with an adhesive described below in a three layer structure of PPS-F-1/PET-F-1/PPS-F-1. In lamination process, the adhesive was applied on one surface of PPS-F-1 by gravure coater method. The application thickness of the adhesive was controlled so as to be 5 μm after the solvent was dried off. The drying condition was at 100°C and for 5 minutes. The laminating method was a heat press roll method at a temperature of 100°C at a linear pressure of 2 kg. Further, the adhesive was hardened at 40°C and for three days (designated as resin film-1).

- Adhesive: A urethane-based adhesive (ADD COAT 76P1 available from Toyo-Morton, Ltd.) was used. A mixing ratio of a base compound to a hardener was 100/1. An application concentration was controlled so as to be 25% by mass. Ethyl acetate was used as a dilution solvent.

(6) Production of a gas barrier layer

A PET film (LUMIRROR (registered trade mark) S10 available from Toray Industries, Inc.) having a thickness of 12 μm was used as a gas barrier layer supporting film and the film was post-annealed in the same manner as that of the PPS-F-1 in the above item (4) to obtain a film having the heat shrink ratio in the MD at 150°C of +0.7% and the heat shrink ratio in the TD of +0.1%. A silicon oxide film was formed in a thickness of 800 Å on the film by a sputtering method (designated as gas barrier layer-1).

(7) Production of the seal film for solar cell module

As shown in Fig. 4, the gas barrier layer-1 was stacked on one surface of the above obtained resin film-1 with an adhesive in the same method as that of the above item (5) - (b) so that the silicon oxide layer faces the inside. Thus, a seal film (designated as seal film-1) was obtained. The water vapor permeability of the thus obtained seal film was 0.5 g/$m^2$/24hr.

EXAMPLE 2

A PPS film is formed in the same method as that of the Example 1. A heat treatment temperature after stretching was 260°C. A post-annealing temperature was 150°C. The thus obtained film having a thickness of 25 μm was designated as PPS-F-2. The orientation factors OF of the film were 0.39 in the edge direction and 0.42 in the end direction.

On the other hand, a PET film was formed by the same method as that for the PET-F-1 in Example 1. A post-annealing temperature was 150°C. The obtained film having a thickness of 100 μm was designated as PET-F-2. The above described PPS-F-2 and PET-F-2 were stacked in a three layers structure of PPS-F-2/PET-F-2/PPS-F-2 by the method in Example 1 to form a resin film. The gas barrier layer-1 was further stacked on one surface of the resin film layer by the same method as that of Example 1 to obtain a seal film (designated as seal film-2). The water vapor permeability of the film was 0.5 $g/m^2/24hr$. Table 2 shows the measurements of the heat shrink ratios of the PPS-F-2 and PET-F-2.

EXAMPLE 3

A PPS film was formed by the method of Example 1. A heat treatment temperature was 260°C. Relaxation rate in the width direction in the same tenter was 12%. The orientation factors OF of the film were 0.32 in the edge direction and 0.36 in the end direction. A post-anneal treatment was performed at 150°C for 1 minute using the method of Example 1. The obtained film having a thickness of 25 μm is designated as PPS-F-3. On the other hand, as for a PET film, a PET film having a thickness of 100 μm was formed with stretching magnifications of 3. 5-fold in the longitudinal and width directions and with the same heat treatment conditions and post-annealing conditions as those of the Example 1. This film is designated as PET-F-3.

The PPS-F-3 and the PET-F-1 were stacked in three layers with the same laminating structure and laminating conditions as those of Example 1. Thereafter, the gas barrier layer-1 was stacked thereon by the method of Example 1 to obtain a seal film (designated as seal film-3) . The water vapor permeability of the seal film was 0.5 $g/m^2/24hr$. Table 2 shows the values of the heat shrink ratios of the PPS-F-3 and PET-F-3.

COMPARATIVE EXAMPLE 1

A PPS film was formed with the same method and conditions as those in Example 1, except that stretching was performed with a stretching magnification of 3.9-fold in the longitudinal direction and a stretching magnification of 3.7-fold in the width direction. No post-annealing treatment was performed. The thus obtained PPS film having a thickness of 25 μm was designated as a PPS-F-4. The orientation factors of the film were 0.30 in the edge direction and 0.38 in the end direction.

A PET film was also formed by the method of Example 2. No post-annealing treatment was performed.

The thus obtained PET film having a thickness of 100 μm is designated as a PET-F-4. The PPS-F-4 and the PET-F-4 were stacked in three layers by the same method of Example 1. Thereafter, the gas barrier layer- 1 was stacked thereon by the method of Example 1 to obtain a seal film (designated as seal film-4). The water vapor permeability of the seal film was also 0.5 $g/m^2/24hr$. Table 2 shows the values of the heat shrink ratios of the PPS-F-4 and PET-F-4.

EXAMPLE 4

A PPS film was formed by the method of Example 1. The film was stretched at a stretching magnification of 3.5-fold in the longitudinal and 3-fold in the width direction. A heat treatment temperature after stretching was 270°C. The relaxation rate in the width direction was 17% (orientation factors OF: 0.41 in the edge direction, 0.50 in the end direction). The post-annealing process was performed under the conditions of Example 1. The obtained PPS film having a thickness of 25 μm is designated as PPS-F-5. The PET film was also stretched with the same conditions and method as those of Example 1. The stretching magnification in the longitudinal direction was 3. 0 and the stretching magnification in the width direction was 2.4. A heat treatment temperature after stretching was 220 °C. The conditions of Example 1 were employed as the post-annealing conditions.

The thus obtained PET film having a thickness of 100 μm is designated as PET-F-5. The PPS-F-5 and the PET-F-5 were stacked in three layers by the method of Example 1. The gas barrier layer- 1 was stacked thereon by the method of Example 1 to obtain a seal film (designated as a seal film-5). The water vapor permeability of the seal film was also 0.5 $g/m^2/24hr$. Table 2 shows the values of the heat shrink ratio of the PPS-F-5 and PET-F-5.

COMPARATIVE EXAMPLE 2

A PPS film was formed under conditions of Example 1 and by the method of Example 1 at a stretching magnification of 4.2-fold in the longitudinal direction and a stretching magnification of 3.0-fold in the width direction, at a heat treatment temperature of 270°C and at a relaxation rate of 7% in the width direction (orientation factor OF: 0.38 in the edge direction and 0.59 in the end direction). No post-annealing treatment was performed. The PPS film having a thickness of 25 μm is designated as PPS-F-6. A PET film was formed by the method of Example 1. The stretching magnification in the longitudinal direction was 3.8-fold, and the stretching magnification in the width direction was 2.5-fold in the width directions. The relaxation rate in the width direction was 5%. No post-annealing treatment was performed. The PET film having a thickness of 100 μm is designated as PET-F-6. The PPS-F-6 and the PET-F-6 were stacked in three layers by the method of Example 1. The gas barrier layer-1 was thereafter stacked thereon by the method of Example 1 to obtain a seal film (designated as a seal film-6). The water vapor permeability of the seal film was also 0.5 $g/m^2/24hr$. Table 2 shows the values of the heat shrink ratios of the PPS-F-6 and PET-F-6.

EXAMPLE 5

A PPS film having a thickness of 12 μm was obtained by the same method as that of Example 1 except that only the amount of the molten polymer outputted through a T die was changed. The film is designated as PPS-F-7. One surface of the film was subjected to a plasma treatment in argon gas flow. Conditions were a pressure of 40 Pa, a treatment rate of 1 m/minute and a treatment strength (value calculated from the formula: applied voltage/(treatment rate × electrode width) of 500 $W•min/m^2$. A silicon oxide film was formed on the plasma-treated surface by a sputtering method of Example 1 (designated as gas barrier layer-2). On the other hand, the PET film was controlled so as to have a thickness of 125 μm by the method of Example 1 except that the amount of the polymer outputted through a T die was changed. The obtained PET film is designated as PET-F-7. Next, the above obtained gas barrier layer-2, PET-F-7 and PPS-F-7 were then stacked in this order by the method of Example 1 to obtain a seal film (designated as seal film-7) (Here, lamination was performed so that the sputtering-treated surface of the gas barrier layer-2 faced the PET-F-7. The water vapor permeability of the seal film was controlled so as to be 0.5 $g/m^2/24hr$). Table 2 shows the values of the heat shrink ratios of the PPS-F-7 and PET-F-7.

EXAMPLE 6

A PPS film having a thickness of 9 μm was obtained by the same method as that of Example 1 except that the amount of the molten polymer outputted through a T die was changed. The film is designated as PPS-F-8. One surface of the film was plasma-treated by the method of Example 5 to form a silicon oxide film (gas barrier layer-3). As for a PET film, a film having a thickness of 150 μm was obtained also by the same method as that of Example 5 except that the amount of the molten polymer outputted through a T die was changed (designated as PET-F-8). Three kinds of the films were stacked in three layers by the method of Example 5 to obtain a seal film (designated as seal film-8). The water vapor permeability of the seal film was controlled so as to be 0.5 $g/m^2/24hr$. Table 2 shows the values of the heat shrink ratios of the PPS-F-8 and PET-F-8.

EXAMPLE 7

A PPS film having a thickness of 6.5 μm was obtained by the same method as that of Example 5 except that the amount of the molten polymer outputted through a T die was changed (PPS-F-9). One surface of the film was provided with a silicon oxide film by the method of Example 5 to obtain a gas barrier layer-4. The PET-F-8 was used as a PET film. Three kinds of the films were stacked in the same structure by the method of Example 5 to obtain a seal film-9. The water vapor permeability of the seal film was controlled so as to be 0. 5 $g/m^2/24hr$. Table 2 shows the values of the heat shrink ratios of the PPS-F-9 and PET-F-9.

EXAMPLE 8

A PPS resin composition was formed by the method of Example 1. The composition was dried in vacuum. The vacuum drying condition was a temperature of 140°C, a vacuum degree of 10 mmHg and a drying time of only 7 hours. The high temperature volatile content of the resin composition after drying was 0.26% by mass. The PPS resin composition was formed into a biaxially oriented film by the method of Example 1 to obtain PPS-F-10 having a thickness of 25 μm. The high temperature volatile content of the film was 0.022% by mass. The film, and the PET-F-1 and gas barrier layer-1 used in Example 1 were stacked by the method of Example 1 to obtain a seal film (designated as seal film-10). The water vapor permeability thereof was controlled so as to be 0.5 $g/m^2/24hr$. Table 2 shows the value of the heat shrink ratio of the PPS-F-10.

EXAMPLE 9

A PPS resin composition was formed by the method of Example 1. The composition was dried in vacuum. The vacuum drying condition was a temperature of 140°C, a vacuum degree of 70 mmHg and a drying time of only 7 hours. The high temperature volatile content of the resin composition after dried was 0.35% by mass. The PPS resin composition was formed into a biaxially oriented film by the method of Example 1 to obtain PPS-F-11 having a thickness of 25 μm. The high temperature volatile content of the film was 0.027% by mass. The film, and the PET-F-1 and gas barrier layer-1 used in Example 1 were stacked by the method of Example 1 to obtain a seal film (designated as a seal film-11). The water vapor permeability was controlled so as to be 0.5 $g/m^2/24hr$. Table 2 shows the value of the heat shrink ratio of the PPS-F-11.

A seal film for solar cell module provided with a weather resistant resin layer was formed by the following method. (1) The following three kinds of films were prepared. PPS-F-1, PET-F-1, gas barrier layer-1

(2) A benzotriazole-based monomer copolymerized acryl resin described below was prepared as a weather resistant resin.

An coating material (PUVA-30M available from Otsuka Chemical Co., Ltd.) was prepared. The coating material was formed by mixing a copolymer of 2-(2,-hydroxy-5,-methacryloxyethylphenyl)-2H-benzotriazole/ methyl methacrylate = 30/70 % by mass with butyl acetate so that the coating material may have a solid content concentration of 30% by mass.

(3) Lamination of a weather resistant resin

Both surfaces of the PPS-F-1 were corona-discharge-treated at an energy of 6000 $J/m^2$. The coating material described in the above item (2) was applied to one of the surfaces of the PPS-F-1 by a gravure coater method. The application thickness was adjusted to be 5 μm after drying. Thus, a laminated film was obtained (designated as a weather resistant layer-1). Drying conditions were a temperature of 120°C and 2 minutes.

(4) Production of a seal film for solar cell module

The gas barrier layer-1, the PPS-F-1, the PET-F-1 and the weather resistant film layer-1 were stacked in this order to obtain a seal film (designated as seal film-12) by the method of Example 1. In addition, the water vapor permeability thereof was controlled so as to be 0.5 $g/m^2/24hr$.

EXAMPLES 11 to 20 and COMPARATIVE EXAMPLES 3 and 4

The seal films of Examples 1 to 10 (seal films 1 to 3, 5, and 7 to 12) and the seal films of Comparative Examples 1 and 2 (seal films 4 and 6) were used to produce twelve solar cell modules described below. These solar cell modules are designated as solar cell modules 1 to 12.

A flat glass (float plate glass available from ASAHI GLASS CO., LTD.) generally called a white plate glass having a thickness of 4 mm was prepared as the front sheet layer. An electrical lead wire was formed on the gas barrier layer side of each of the above seal films with a construction of 400-μm thick EVA sheet/solar cell elements (PIN type solar cell elements bonded with a bonding film)/400-μm thick EVA sheet/plate glass and then thermal press-bonding was performed by a known vacuum laminate method. The laminating temperature was 150°C. Relationships between the twelve solar cell modules thus obtained and the seal films employed are as shown in Table 1.

[Table 1]

| | Employed seal film for solar cell module No. | Obtained solar cell module No. |
|---|---|---|
| Example 11 | Seal film-1 | Solar cell-1 |
| Example 12 | Seal film-2 | Solar cell-2 |
| Example 13 | Seal film-3 | Solar cell-3 |
| Comparative Example 3 | Seal film-4 | Solar cell-4 |
| Example 14 | Seal film-5 | Solar cell-5 |
| Comparative Example 4 | Seal film-6 | Solar cell-6 |
| Example 15 | Seal film-7 | Solar cell-7 |

(continued)

| | Employed seal film for solar cell module No. | Obtained solar cell module No. |
|---|---|---|
| Example 16 | Seal film-8 | Solar cell-8 |
| Example 17 | Seal film-9 | Solar cell-9 |
| Example 18 | Seal film-10 | Solar cell-10 |
| Example 19 | Seal film-11 | Solar cell-11 |
| Example 20 | Seal film-12 | Solar cell-12 |

Table 2 shows the value of heat shrink ratios of the PPS films and the PET films obtained in Examples 1 to 10 and Comparative Examples 1 and 2.

[Table 2]

| | Heat shrink ratio of PPS-F (%) | | Heat shrink ratio of PET-F (%) | | Seal film No. |
|---|---|---|---|---|---|
| | MD | TD | MD | TD | |
| Example 1 | 0.70 | 0.20 | 0.50 | -0.02 | Seal film-1 |
| Example 2 | 1.23 | 0.41 | 1.05 | 0.32 | Seal film-2 |
| Example 3 | 1.88 | 1.21 | 1.75 | 0.85 | Seal film-3 |
| Comparative Example 1 | 2.15 | 1.37 | 2.23 | 1.28 | Seal film-4 |
| Example 4 | 1.17 | -0.41 | 1.09 | -0.90 | Seal film-5 |
| Comparative Example 2 | 1.85 | -0.45 | 1.62 | -0.55 | Seal film-6 |
| Example 5 | 0.75 | 0.15 | 0.63 | 0.10 | Seal film-7 |
| Example 6 | 0.65 | 0.12 | 0.70 | 0.10 | Seal film-8 |
| Example 7 | 0.72 | 0.07 | 0.70 | 0.10 | Seal film-9 |
| Example 8 | 0.70 | 0.20 | 0.50 | -0.02 | Seal film-10 |
| Example 9 | 0.68 | 0.20 | 0.50 | -0.02 | Seal film-11 |
| Example 10 | 0.70 | 0.20 | 0.50 | -0.02 | Seal film-12 |

Tables 3 to 5 comparatively show the evaluation results of Examples and Comparative Examples.

[Table 3]

| | Heat shrink ratio (%) | | Difference in heat shrink ratio (%) | Laminating ratio A/B (%) | High temperature volatile content (% by weight) | Water vapor permeability after aging ($g/m^2/24hr$) | Hydrolysis resistance (%) | Seal film No. |
|---|---|---|---|---|---|---|---|---|
| | MD | TD | | | | | | |
| Example 1 | 0.63 | 0.12 | 0.51 | 31 | 0.016 | 0.5 (V) | 80 (V) | Seal film-1 |
| Example 2 | 1.22 | 0.39 | 0.83 | 31 | 0.016 | 1.0 (V) | 81 (V) | Seal film-2 |
| Example 3 | 1.83 | 1.02 | 0.81 | 31 | 0.016 | 5.1 (G) | 77 (V) | Seal film-3 |
| Comparative Example 1 | 2.20 | 1.34 | 0.86 | 31 | 0.016 | 6.9 (P) | 72 (V) | Seal film-4 |

(continued)

| | Heat shrink ratio (%) | | Difference in heat shrink ratio (%) | Laminating ratio A/B (%) | High temperature volatile content (% by weight) | Water vapor permeability after aging ($g/m^2$/24hr) | Hydrolysis resistance (%) | Seal film No. |
|---|---|---|---|---|---|---|---|---|
| | MD | TD | | | | | | |
| Example 4 | 1.14 | -0.72 | 1.86 | 31 | 0.016 | 3.5 (V) | 75 (V) | Seal film-5 |
| Comparative Example 2 | 1.71 | -0.49 | 2.20 | 31 | 0.016 | 6.5 (P) | 72 (V) | Seal film-6 |
| Example 5 | 0.65 | 0.10 | 0.55 | 16 | 0.016 | 0.6 (V) | 60 (V) | Seal film-7 |
| Example 6 | 0.70 | 0.10 | 0.60 | 11 | 0.016 | 0.6 (V) | 51 (V) | Seal film-8 |
| Example 7 | 0.70 | 0.11 | 0.59 | 8 | 0.016 | 0.5 (V) | 41 (G) | Seal film-9 |
| Example 8 | 0.63 | 0.12 | 0.51 | 31 | 0.022 | 0.5 (V) | 77 (V) | Seal film-10 |
| Example 9 | 0.62 | 0.11 | 0.51 | 31 | 0.027 | 0.5 (V) | 78 (V) | Seal film-11 |
| Example 10 | 0.62 | 0.11 | 0.51 | 31 | 0.016 | 0.5 (V) | 82 (V) | Seal film-12 |

[Table 4]

| | Weather resistance A (%) | Weather resistance B | Heat resistance (%) | Toxic-gas resistance (%) | Overall evaluation | Seal film No. |
|---|---|---|---|---|---|---|
| Example 1 | 56 (V) | E | 70 (V) | 57 (V) | V | Seal film-1 |
| Example 2 | 54 (V) | E | 70 (V) | 56 (V) | V | Seal film-2 |
| Example 3 | 50 (V) | E | 68 (V) | 55 (V) | G | Seal film-3 |
| Comparative Example 1 | 47 (V) | E | 65 (V) | 55 (V) | P | Seal film-4 |
| Example 4 | 52 (V) | E | 68 (V) | 56 (V) | V | Seal film-5 |
| Comparative Example 2 | 45 (V) | E | 66 (V) | 55 (V) | P | Seal film-6 |
| Example 5 | 52 (V) | E | 66 (V) | 48 (V) | V | Seal film-7 |
| Example 6 | 50 (V) | E | 60 (V) | 40 (V) | V | Seal film-8 |
| Example 7 | 47 (V) | E | 52 (G) | 30 (G) | G | Seal film-9 |
| Example 8 | 39 (G) | V | 72 (V) | 54 (V) | G | Seal film-10 |
| Example 9 | 33 (G) | G | 70 (V) | 55 (V) | G | Seal film-11 |
| Example 10 | 88 (V) | E | 70 (V) | 56 (V) | V | Seal film-12 |

[Table 5]

| | Reduction ratio in the output of the solar cell module (%) | Judgment | Employed seal film | Solar cell module No. |
|---|---|---|---|---|
| Example 11 | 2 (V) | (V) | Seal film-1 | Solar cell-1 |
| Example 12 | 4 (V) | (V) | Seal film-2 | Solar cell-2 |
| Example 13 | 8 (G) | (G) | Seal film-3 | Solar cell-3 |
| Comparative Example 3 | 12 (P) | (P) | Seal film-4 | Solar cell-4 |
| Example 14 | 5 (V) | (V) | Seal film-5 | Solar cell-5 |
| Comparative Example 4 | 15 (P) | (P) | Seal film-6 | Solar cell-6 |
| Example 15 | 2 (V) | (V) | Seal film-7 | Solar cell-7 |
| Example 16 | 3 (V) | (V) | Seal film-8 | Solar cell-8 |
| Example 17 | 9 (G) | (G) | Seal film-9 | Solar cell-9 |
| Example 18 | 7 (G) | (G) | Seal film-10 | Solar cell-10 |
| Example 19 | 9 (G) | (G) | Seal film-11 | Solar cell-11 |
| Example 20 | 2 (V) | (V) | Seal film-12 | Solar cell-12 |

Tables 3 and 4 show the evaluation results of the seal film for solar cell module of the present invention. Table 5 shows the evaluation results of the solar cell module using the seal films for solar cell module.

It is understood that the seal film for solar cell module of the present invention has the following characteristics. That is, deterioration due to a harsh external environmental (high temperature, high humidity, generated toxic gas, ultra-violet light and the like), is prevented; deterioration of the gas barrier properties due to long-term use is prevented, which has been a problem of the prior art; environmental resistance properties (heat resistance, hydrolysis resistance, weather resistance, chemical resistance and the like) ; and thus long-term reliability is further excellent. These are enabled by using a PPS film in some of the film layers of the seal film for solar cell module and by controlling the heat shrink ratios of the seal film layer and the balance of the longitudinal and width direction heat shrink ratios of the layer within a particular range.

In the solar cell module using the seal film for solar cell module of the present invention, the reduction in the output due to the penetration of water vapor can be drastically improved. The solar cell module has such a long life that the solar cell module is resistant to deterioration due to hydrolysis, ultra-violet light and toxic gas, and withstands harsh environments. The solar cell module may also achieve weight reduction and high mechanical strength.

That is, among the seal films of Examples 1 to 4 (seal films-1 to 3, and 5) and the seal film of Comparative Example 1 (seal film-4), the heat shrink ratios at 150°C of the resin film layers of the seal films are varied while the differences between longitudinal and width direction heat shrink ratios are kept almost constant.

It is understood that the greater the heat shrink ratios become, the worse the gas barrier properties (water vapor permeability) referred to in the present invention become. It is also understood that, if any one of the longitudinal and width direction heat shrink ratios is out of a range of -2.0% to +2.0% like the seal film of Comparative Example 1 (seal film-4), the gas barrier properties significantly deteriorate.

Between the seal film of Example 4 (seal film-5) and the seal film of Comparative Example 2 (seal film-6), the differences between longitudinal and width direction heat shrink ratios at 150°C of the seal film are varied. Comparison with the seal film of Example 1 (seal film-1) reveals that when the difference between heat shrink ratios in both of the axes increases, gas barrier properties tend to deteriorate. When the difference in heat shrink ratio exceeds 2.0%, gas barrier properties significantly deteriorate. Consequently, extension of the service life of the solar cell module cannot be achieved, the extension being an object of the present invention.

Evaluation results of the solar cell modules using the above seal film in Examples 11 to 14 and Comparative Examples 3 and 4 are shown (Table 5). It is understood that the output of the solar cell module after long-term use can be reduced by making the longitudinal and width direction heat shrink ratios at 150°C be both within a range of -2.0% to +2.0% and making the difference between heat shrink ratios in both axes be 2.0% or less.

Among the seal films of Examples 5 to 7 (seal film-7 to 9), the laminating thickness ratios of the PPS films used

in the resin film layers of the seal films are changed. Comparison with the seal film of Example 1 (seal film-1) reveals that, when the thickness ratio of the PPS film is reduced, hydrolysis resistance, heat resistance, toxic-gas resistance and the like which are required as resistance against harsh environment in which the solar cell module is placed is also reduced.

Meanwhile, it is understood that the thickness ratio is preferably 10% or more to achieve an object of the present invention.

The solar cell modules using these seal films are evaluated in Examples 15 to 17. The evaluation results clearly show that the above characteristics affect the output variation of the solar cell module.

Between the seal films of Examples 8 and 9 (seal films-10 and 11), the high temperature volatile contents contained in the PPS films employed are different from each other. Comparison with the seal film of Example 1 reveals that it is advantageous that the high temperature volatile content is 0.02% or less from the viewpoint of weather resistance (ultra-violet resistance).

Meanwhile, the seal film of Example 10 (seal film-12) is one in which a acryl-based weather resistant resin is provided on the outer surface of the PPS film layer being the outermost layer of the seal film (seal film-1) of Example 1. It is understood that the weather resistance (ultra-violet light resistance) is further improved without deteriorating the characteristics of the solar cell module.

Therefore, as for the solar cell module of the present invention, when the seal film of the present invention is applied to a field requiring high weather resistance or the seal film of the present invention is applied to the front sheet side of the solar cell module, it is advantageous that the seal film B stacked with a weather resistant resin is used.

## Claims

1. A seal film for solar cell module **characterized by** comprising:

   a resin film layer including a biaxially oriented film layer formed of a resin composition containing poly-p-phenylene sulfide as a major component; and
   a gas barrier layer formed of at least one selected from the group consisting of a metal, a metal oxide, an inorganic compound, and an organic compound, **characterized in that**
   longitudinal and width direction heat shrink ratios at 150°C of the seal film for solar cell module are both within a range of -2.0% to +2.0%, and
   an absolute value of a difference between the longitudinal and width direction heat shrink ratios at 150°C is 2.0% or less.

2. The seal film for solar cell module according to claim 1, **characterized in that** a ratio (laminating ratio: B/A×100) of an overall thickness (B) of the biaxially oriented film layer to the thickness (A) of the seal film for solar cell module is 10% or more, the biaxially oriented film layer forming the seal film and being formed of the resin composition containing poly-p-phenylene sulfide as the major component.

3. The seal film for solar cell module according to claim 1, **characterized in that** a high temperature volatile content of the biaxially oriented film formed of the resin composition containing poly-p-phenylene sulfide as the major component is 0.02% by mass or less.

4. A seal film for solar cell module **characterized in that** a weather resistant resin layer is stacked on at least one surface of the seal film for solar cell module according to claim 1.

5. A solar cell module **characterized by** comprising the seal film for solar cell module according to any one of claims 1 to 4 disposed on at least one surface thereof.

Fig. 1

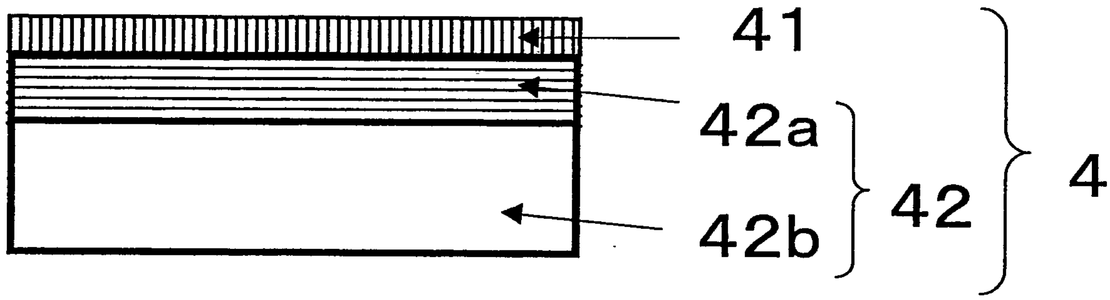


Fig. 2

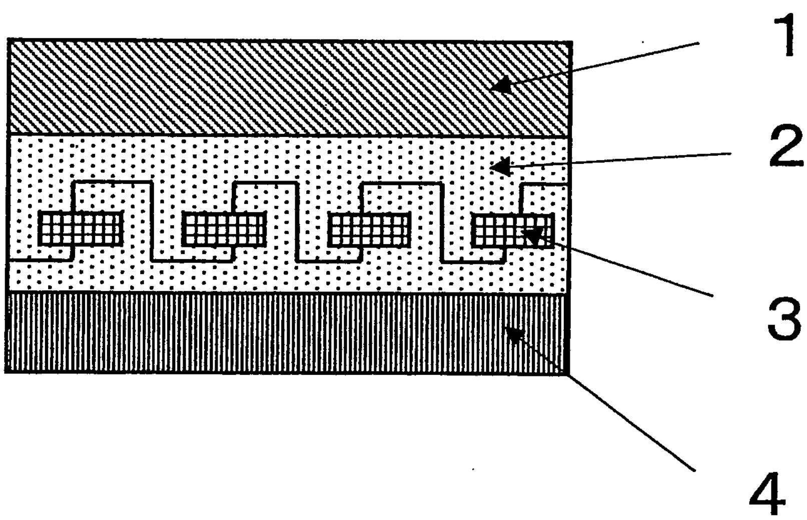

Fig. 3

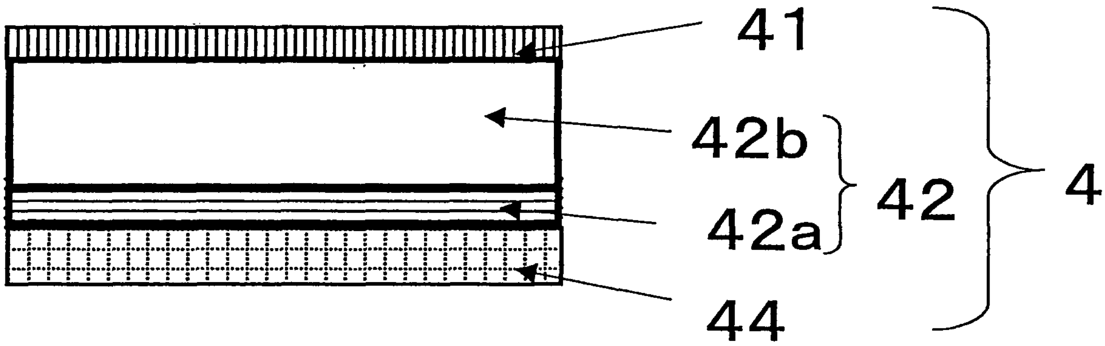


Fig. 4

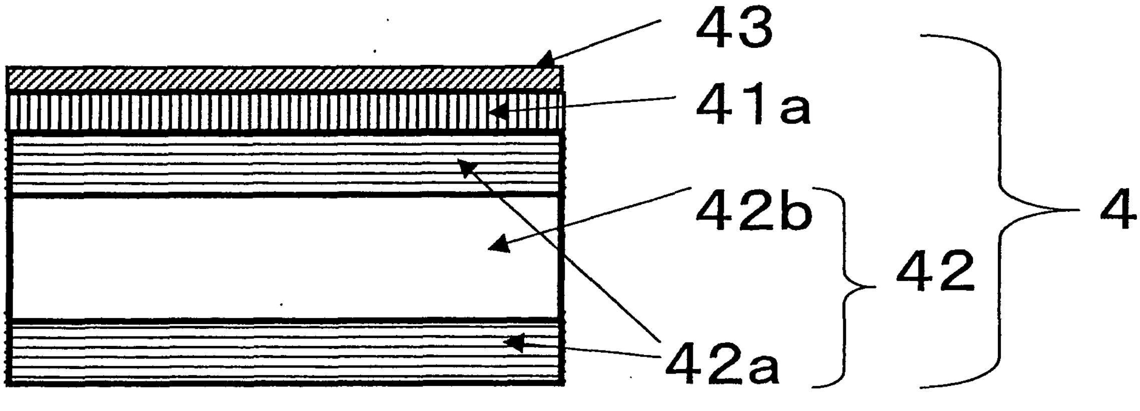

## INTERNATIONAL SEARCH REPORT

International application No.
PCT/JP2007/066517

A. CLASSIFICATION OF SUBJECT MATTER
*H01L31/042*(2006.01)i, *B32B27/00*(2006.01)i

According to International Patent Classification (IPC) or to both national classification and IPC

B. FIELDS SEARCHED

Minimum documentation searched (classification system followed by classification symbols)
*H01L31/04*(2006.01)i-*H01L31/078*(2006.01)i, *B32B27/00*(2006.01)i

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2002-83978 A (Sanyo Electric Co., Ltd.), 22 March, 2002 (22.03.02), Par. Nos. [0033] to [0034] & US 2002/0020440 A1 & EP 1172864 A1 | 1-5 |
| Y | JP 2005-86104 A (Sharp Corp.), 31 March, 2005 (31.03.05), Par. No. [0009] (Family: none) | 1-5 |
| Y | JP 2002-289889 A (Mitsubishi Electric Corp.), 04 October, 2002 (04.10.02), Par. Nos. [0054] to [0056] (Family: none) | 1-5 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 10 September, 2007 (10.09.07) | 18 September, 2007 (18.09.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2007/066517

C (Continuation). DOCUMENTS CONSIDERED TO BE RELEVANT

| Category* | Citation of document, with indication, where appropriate, of the relevant passages | Relevant to claim No. |
|---|---|---|
| A | JP 3-185769 A (Canon Inc.), 13 August, 1991 (13.08.91), Page 2, lower left column (Family: none) | 1-5 |
| A | JP 11-40833 A (Toray Industries, Inc.), 12 February, 1999 (12.02.99), Par. No. [0058] (Family: none) | 1-5 |
| A | JP 2000-12880 A (Kobe Steel, Ltd.), 14 January, 2000 (14.01.00), Par. No. [0036] (Family: none) | 1-5 |
| A | JP 55-35459 A (Toray Industries, Inc.), 12 March, 1980 (12.03.80), Full text & US 4286018 A & GB 2019770 A & DE 2916841 A1 & FR 2432529 A1 | 1-5 |
| A | JP 11-307789 A (Canon Inc.), 05 November, 1999 (05.11.99), Par. No. [0039] (Family: none) | 1-5 |
| A | JP 2000-332275 A (Dainippon Printing Co., Ltd.), 30 November, 2000 (30.11.00), Par. No. [0025] & US 6335479 B1 & EP 1054456 A2 | 1-5 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000138387 A
- JP 2002100788 A
- JP 2002026354 A
- JP 2003031824 A
- JP 2005086104 A
- JP SHO5535459 B
- JP SHO5422234 B